# EUROPEAN PATENT SPECIFICATION

(11) **EP 3 412 794 B1**
(45) Date of publication and mention of the grant of the patent: **05.04.2023**
(21) Application number: 17743543.5
(22) Date of filing: 03.01.2017
(51) Int. Cl.: C23C 14/24, C23C 14/34, C23C 14/54, C22C 21/00, C23C 2/06, C23C 2/28, C23C 2/40, C23C 28/02, C23C 28/00

(54) **COATING DEVICE WITH MOVING TARGET AND COATING METHOD**
BESCHICHTUNGSVORRICHTUNG MIT BEWEGLICHEM ZIEL UND BESCHICHTUNGSVERFAHREN
DISPOSITIF DE REVÊTEMENT AVEC CIBLE MOBILE ET PROCÉDÉ DE REVÊTEMENT

(30) Priority: 26.01.2016 CN 201610053369
(43) Date of publication of application: 12.12.2018
(73) Proprietor: BOE Technology Group Co., Ltd., Beijing 100015 (CN); Hefei Xinsheng Optoelectronics Technology Co., Ltd., Xinzhan Industrial Park Hefei Anhui 230012 (CN)
(72) Inventor: QIAN, Guoping, Beijing 100176 (CN); JING, Yangkun, Beijing 100176 (CN); WU, Chengye, Beijing 100176 (CN); WANG, Bei, Beijing 100176 (CN); JI, Yu, Beijing 100176 (CN)
(74) Representative: Klunker IP Patentanwälte PartG mbB
(86) International application number: PCT/CN2017/000038
(87) International publication number: WO 2017/128928

(56) References cited:
- CN-A- 103 484 826
- CN-A- 105 483 619
- CN-U- 202 643 828
- JP-A- H09 263 939
- JP-A- 2005 327 846
- US-A- 4 324 631
- US-A1- 2002 100 680
- US-A1- 2009 104 721
- US-A1- 2010 243 427

## Description

### TECHNICAL FIELD

The present invention relates to a mobile target coating device (or coating device with moving target) and coating method, and especially relates to a mobile target coating device comprising an infrared temperature detecting section and an infrared heating section as well as the coating method.

### BACKGROUND

Organic light-emitting diode (OLED) display devices have advantages, such as self-illumination, high contrast, thin thickness, wide viewing angle, fast response, availability for flexible panels, wide working temperature range, simple construction and process and etc., and have become one of the mainstream developments of the current flat display technology. In the process of preparing organic light emitting devices, the use of mobile targets for coating is a way to improve the target utilization rate.

US 4 324 631 A discloses a technique for using the thermal energy inherent in the sputtering process for initially heating the target material to its Curie temperature, thereby rendering the material non-magnetic, and for maintaining the target temperature at or above such temperature during the sputtering process.

US 2009/104721 A1 inter alia discloses a deposition method comprising the steps of: a first step of aligning a deposition target substrate and a mask which has a smaller area than the deposition target substrate; a second step of irradiating a supporting substrate with light from a light source unit, and heating the evaporation material by making irradiation light absorbed in the light absorption layer, wherein a light absorption layer is provided over the supporting substrate, and wherein an evaporation material is provided over the light absorption layer; a third step of vaporizing at least part of the evaporation material, and depositing the vaporized evaporation material on at least part of a surface of the deposition target substrate through an opening of the mask; and a fourth step of moving one of the deposition target substrate and the mask, wherein the first step through the fourth step repeat plural times.

CN 103 484 826 A discloses a magnetron sputtering cathode movement target, which comprises a sealed vacuum container, a sputtering target, a heater, a baffle, a cathode support base, a cathode water cooling back plate, a cathode water cooling vacuum sealing base, a magnet, a cathode body movement vacuum sealing system, and a work-piece, wherein a plated work-piece passes through the position between the heater and the baffle, a movement cathode body is arranged inside the sealed vacuum container and comprises the cathode body movement vacuum sealing system so as to achieve precise cathode body movement outside the sealed vacuum container, the magnet is adhered on the cathode water cooling vacuum sealing base through a glue, the cathode water cooling back plate and the cathode support base form the movement portion of the cathode body, and the sputtering target is fixed on the cathode water cooling back plate through a mechanical fixation manner. The magnetron sputtering cathode movement target has the following advantages that: the relative velocity between the magnetic field and the work-piece is always equal to the movement velocity of the work-piece, such that the plating film uniformity problem does not exist; and a sputtering area of the sputtering target is increased so as to increase target utilization rate, substantially reduce product production cost, save resources and improve competitiveness.

CN 202 643 828 U discloses a comparable magnetron sputtering cathode movement target.

JP H09 263939 A discloses a heater including a transporting car on which a substrate or a wafer is mounted and which transports the substrate or the wafer and the heating means which heat the substrate or the wafer under transportation. Tubular heaters having a flat output characteristic in the longitudinal direction are used as the heating means. A plurality of these tubular heaters are disposed in such a manner that the axial direction of the tubular heater parallels with the transporting direction of the substrate or the wafer.

### SUMMARY

It is an object of the present invention to provide a mobile target coating device comprising an infrared temperature detecting section and an infrared heating section as well as the coating method.

The object is achieved by the features of the respective independent claims. Further embodiments are defined in the corresponding dependent claims.

### BRIEF DESCRIPTION OF THE DRAWINGS

In order to clearly illustrate the technical solution of the embodiments of the disclosure, the drawings of the embodiments will be briefly described in the following; the described drawings are only related to some embodiments of the disclosure and thus are not limitative of the disclosure.
Fig. 1 is a structural schematic view of a mobile target coating device provided by an embodiment of the present disclosure;
Fig.2 is a structural schematic view of a mobile target coating device provided by another embodiment of the present disclosure;
Fig.3 is a top view of the target source and the infrared heating section of a mobile target coating device provided by an embodiment of the present disclosure;
Fig.4 is a top view of the target source and the infrared heating section of a mobile target coating device provided by another embodiment of the present disclosure; and
Fig.5 is a structural schematic view of the infrared heating radiating sheet and the rotating motor of a mobile target coating device provided by an embodiment of the present disclosure.

### DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. Also, the terms such as "a," "an," etc., are not intended to limit the amount, but indicate the existence of at least one. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly.

Organic optoelectronic devices, such as thin film transistors (TFTs), light emitting diodes (LEDs) and photovoltaic (PV) batteries, have drawn considerable attention among researchers in the past decade. Organic semiconductors can be deposited on a variety of substrates, which, when compared to inorganic semiconductors, will potentially simplify manufacturing and reduce costs. Despite the above advantages, organic semiconductors have unique processing requirements which may also limit their application. For example, a light emitting device and a photovoltaic cell (PV) battery are typically obtained from a film of conjugated polymers or monomers sandwiched between conductive electrodes. For full-color displays and multi-transistor circuits, the active organic layer itself also must be horizontally patterned. However, a typical organic layer is too brittle and therefore is impossible to withstand conventional semiconductor processing methods, such as photolithography, plasma processing, reactive ion etching or the like. Therefore, the researchers have developed a number of manufacturing and patterning techniques to adapt to the unique properties of organic materials, these technologies mainly emphasize the ease of processing and reduction of costs.

In the preparation of organic light emitting devices, the use of mobile targets for coating is a way to improve the target utilization rate. However, in the existing methods, the change in the crystallization temperature of a thin film leads to deterioration of the uniformity of the film formation. An embodiment of present disclosure uses an infrared heating section and an infrared temperature detecting section in combination, can ensure that the surface temperature of the moving target source is stable, and no temperature anomalies occur during the entire coating process, thus ensuring the uniformity of the coated film.

An embodiment of the present disclosure provides a mobile target coating device, which comprises a target source, a target source carrier section, an infrared temperature detecting section for detecting the surface temperature of the target source, an infrared heating section for heating the target source, and a control section. The target source carrier section carries the target source and can drive the target source to move, and for driving the target source to move, for example, the target source carrier section carries the target source and both make a synchronized motion; the infrared temperature detecting section and the infrared heating section are in signal communication with the control section, the control section receives detection signals from the infrared temperature detecting section and determines whether the temperature of the surface of the target source is uniform, when the control section determines that the temperature of a portion of the surface of the target source is lower than the temperature of other portions and the temperature difference value exceeds a pre-set value, the control section controls the infrared heating section to heat the surface of the target source at the portion having a lower temperature, and to stop heating when the surface temperature of the target source is uniform.

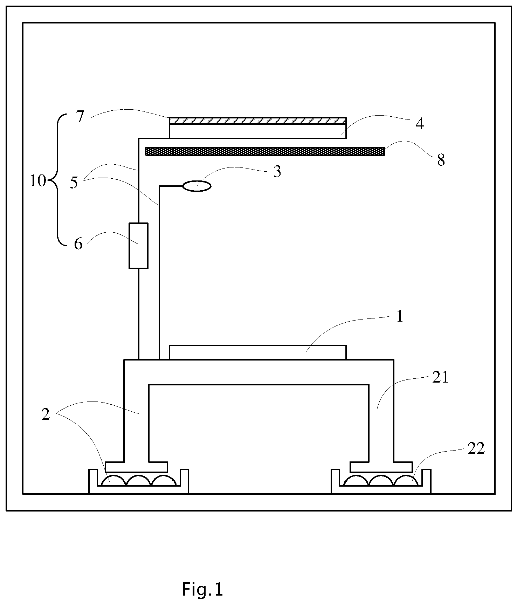

Fig.1 is a schematic view of a mobile target coating device provided by an embodiment of the present disclosure. As illustrated in the drawing, the mobile target coating device comprises a target source 1, a target source carrier section 2, an infrared temperature detecting section 3 for detecting the surface temperature of the target source, an infrared heating section 4 for heating the target source, and a control section 10. The control section 10 may comprise a signal connecting portion 5 and a signal processing section 6; in one example, the control section 10 may further comprise an actuation section 7.

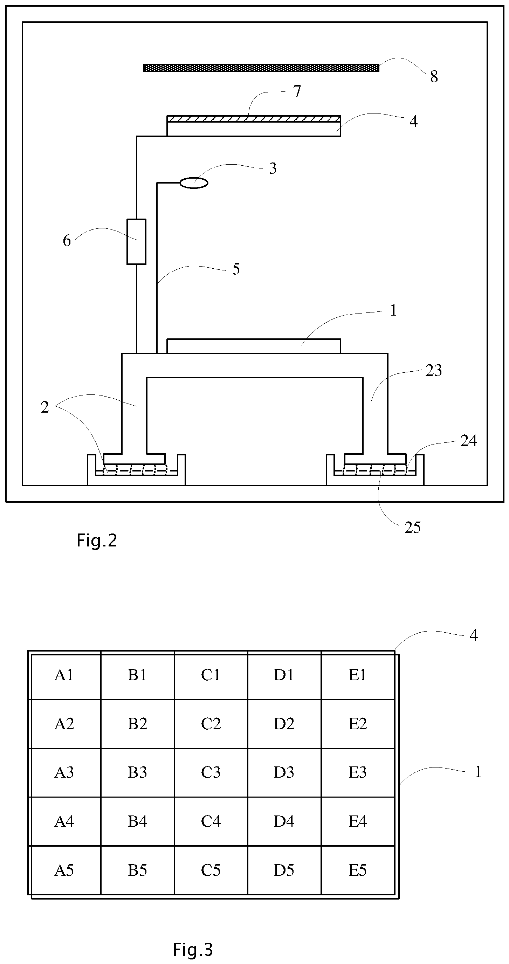

The target source carrier section 2 can carry the target source 1 on its carrying surface, and can drive the target source 1 to move freely in three dimensional directions within the inner space of the mobile target coating device, for example. In the embodiment as illustrated in the drawing, the substrate 8 to be coated is provided between the target source 1 and the infrared heating section 4, and is located in parallel with the target source 1. The size of the substrate 8 is generally greater than or equal to the size of the target source 1. In other examples, for example, as illustrated in Fig.2, the infrared heating section 4 is provided between the substrate 8 to be coated and the target source 1, as long as the infrared heating section does not block the substance sputtered out from the target source 1 from depositing onto the substrate 8 to be coated.

This mobile target coating device can use two manners in the process of conducting coating operation. In the first manner, the target source 1 is fixed at a position to coat the substrate 8 located at the corresponding position, after the film thickness of the substrate 8 at the corresponding position reaches the pre-set thickness, the target source carrier section 2 drives the target source 1 to move to another position and continue to repeat the above process. In the second manner, the target source carrier section 2 drives the target source 1 to move continuously so as to make a scanning-style coating operation to different positions of the substrate 8. The power for driving the target source carrier section 2 may be, for example, from a stepping motor, and the driving mechanism may further comprise guide rails, screw rods, gears and so on.

The target source carrier section 2 may employ a low resistance track. For example, as illustrated in Fig. 1, the target source carrier section 2 comprises a magnetic levitation (maglev) track 22 and a target source support member 21. When the target source 1 needs to be moved, an electromagnetic repulsive force will be generated between the maglev track 22 and the target source support member 21 so as to hold up the target source support member 21 into a suspended state. In this state, the target source support member 21 can be driven to move in the x-axis and/or y-axis direction. The target source support member 21 is configured so as to be movable up and down, for example, by screw rods, or by pinion and rack, and so on.

Fig.2 is a schematic view of a mobile target coating device provided by another embodiment of the present disclosure. As compared with the embodiment illustrated in Fig.1, the target source carrier section 2 of this embodiment as illustrated in Fig.2 comprises an air-cushion track 24 and a target source support member 23, and the air-cushion track 24 is provided with a plurality of air holes 25 facing the target source support member 23; when the target source 1 needs to moved, the plurality of air holes 25 on the air-cushion track 24 eject high-speed gas flows to hold up the target source support member 23 into the suspended state. In this state, the target source support member 23 can be driven to move in the x-axis and/or y-axis direction. The target source support member 23 is provided so as to movable up and down, for example, by screw rods, or by pinion and rack, and so on.

The running speed and acceleration of the target source carrier section 2 are parameters that affect the operating efficiency of the target source carrier section 2; faster running speed and greater acceleration can effectively reduce the time of a single move. Because the target source support member 21/23 is separated from the maglev track 22 or air-cushion track 24, the running speed is effectively improved. Also, in the embodiments of Figs. 1 and 2, the target source carrier section 2 is subjected to a small friction force during movement, and therefore the speed of the target source carrier section 2 is more easily to be increased. In contrast, an existing common target source carrying system suffers from a large track resistance, and in the case where the tasks of transporting the target source become more arduous, the target source carrying system itself encounters frequent shutdown, and at this moment, too fast speed and excessive acceleration speeds up the worn-out of the parts thereof. However, the maglev track system or the air-cushion track system employed in the embodiments of present disclosure can overcome this disadvantage. Due to the separation of the track from the target source support member in the maglev track system or the air-cushion track system, it is possible to eliminate the mechanical friction, depress noise and reduce the mechanical wear of the parts.

For example, the infrared temperature detecting section 3 and the infrared heating section 4 may be connected to the target source carrier section 2, and in this case, when the target source carrier section 2 is moved, the infrared temperature detecting section 3 and the infrared heating section 4 move in synchronism with the target source carrier section 2. This arrangement can ensure that the infrared temperature detecting section 3 can accurately detect the surface temperature of the target source 1, and ensure that the infrared heating section 4 accurately heat a specific position of the surface of the target source 1. Undoubtedly, the infrared temperature detecting section 3 and the infrared heating section 4 can also be provided separately from the target source carrier section 2, and in this case, when the target source carrier section 2 is moved, the infrared temperature detecting section 3 and the infrared heating section 4 move in synchronism with the target source carrier section, or alternatively, the detecting angle, heating angle or the like is adjusted correspondingly.

The signal connecting portion 5 is connects (couples) the infrared temperature detecting section 3 and the signal processing section 6. The signal connecting portion 5 also connects (couples) the signal processing section 6 and the actuation section 7. The signal connecting portion 5 may transmit, for example, electrical signals or optical signals, for example, can be embodied as wires or fibers etc.. The signal connecting portion 5 transfers the information about the surface temperature of the target source 1 detected by the infrared temperature detecting section 3 to the signal processing section 6, the signal processing section 6 processes this temperature information and then the signal connecting portion 5 sends a instruction information of the signal processing section 6 to the actuation section 7, so the actuation section 7 may control/drive the infrared heating section 4.

The signal processing section 6 determines whether the temperature of the surface of the target source 1 is uniform or not according to the detection result received from the infrared temperature detecting section 3. When the signal processing section 6 determines that the temperature at a certain portion of the surface of the target source 1 is lower than the temperatures of other portions and the temperature difference value exceeds a pre-set value, the signal processing section 6 issues an instruction to the actuation section 7, the actuation section 7 controls the infrared heating section 4 to heat the surface of the target source at the portion having a lower temperature until the temperature of the surface of the target source 1 become uniform and stop heating. The above pre-set value for the temperature difference may be selected according to the actually required accuracy, for example, 5 °C, 1 °C, 0.5 °C, 0.1 °C. The judgment criteria regarding whether the temperature of the surface of the target source is uniform or not may also be set according to a practical requirement. For example, it may be set that, when the temperature difference among individual portions of the surface of the target source is less than 5 °C, 1 °C, 0.5 °C or 0.1 °C, the surface temperature of the target source is considered to be uniform.

For example, the target source 1 has an essentially flat target source surface, the infrared heating section 4 may also have an essentially flat infrared heating section surface, and in this case, the target source surface and the infrared heating section surface may be disposed parallel with each other; the normal projections of the target source and the infrared heating section onto the same plane (for example, the plane where the target source is located, or the plane where the infrared heating section is located, or the plane where the substrate is located) at least partially overlap with each other, or alternatively, the normal projection of the infrared heating section and the target source on the same plane at least partially overlap; the infrared temperature detecting section 3 is arranged between the surface of the target source 1 and the surface of the infrared heating section 4.

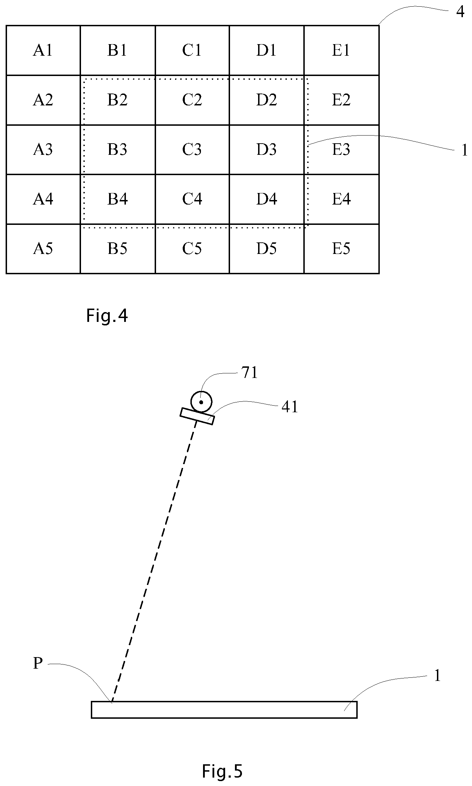

For example, the area size of the target source 1 is less than or equal to the area size of the infrared heating section 4. Figs. 3 and 4 illustrate a top view of the target source 1 and the infrared heating section 4. As illustrated in Fig.3, the area size of the target source 1 and the area size of the infrared heating section 4 are equal to each other, and they are disposed facing each other. Therefore, the target source 1 and the infrared heating section 4 overlap in the top view. As illustrated in Fig.4, the area size of the target source 1 is less than the area size of the infrared heating section 4, and are disposed facing each other. Therefore, the target source 1 is within the range of the infrared heating section 4 in the top view.

For example, the infrared heating section 4 comprises a plurality of infrared heating radiating sheets. As illustrated in Figs. 3 and 4, the infrared heating section 4 comprises 25 infrared heating radiating sheets A1-E5 in total, but the present disclosure is not limited to the shape and arrangement of the infrared heating radiating sheets as illustrated. When the signal processing section 6 determines that the temperature at a certain portion of the surface of the target source 1 is lower than the temperature of other portions and the temperature difference value exceeds the pre-set value, the signal processing section 6 issues an instruction to the actuation section 7, the actuation section 7 actuates the infrared heating radiating sheet(s) opposite to the surface of the target source at the portion having the lower temperature to heat the surface of the portion of the target source 1 having the lower temperature until the temperature of the surface of the target source 1 becomes uniform and then stop heating. For example, the signal processing section 6 detects that the temperature of the target source 1 at its upper left corner is lower than the temperature of other portions and the temperature difference value exceeds the pre-set value, as illustrated in Fig.3, then issues an instruction to the actuation section 7, the actuation section 7 actuates the infrared heating radiating sheet(s) opposite to the upper left corner of the target source 1, i.e., the infrared heating radiating sheet A1 so as to heat the upper left corner of the target source until the temperature of the surface of the target source becomes uniform and then stop heating. In one example, the surface of each of the infrared heating radiating sheets of the infrared heating section 4 may further be provided a radiation converging structure (for example, lens or reflecting part), so it is possible to perform heating to the local position of the target source 1.

For example, as illustrated in Fig.5, the infrared heating section 4 may also comprise an infrared heating radiating sheet 41, the actuation section 7 comprises a rotating motor 71, the infrared heating radiating sheet 41 is connected with the rotating motor 71, and the signal processing section 6 is configured to determine whether the temperature of the surface of the target source is uniform or not; when the signal processing section 6 determines that a certain portion P of the target source surface has a temperature lower than the temperature of other portions, and the temperature difference value exceeds the pre-set value, the signal processing section 6 issues an instruction to the actuation section 7, the rotating motor 71 controls the infrared heating radiating sheet 41 connected therewith to turn on so as to heat the partial target source surface P having the lower temperature until the temperature of the surface of the target source becomes uniform and stop heating.

In the above embodiment, it is also possible to provide, for example, a fan or the like to cooperate with the infrared heating section 4 so as to facilitate the uniformity of the temperature.

For example, the surface of the target source 1 may be in a unity. Alternatively, the surface of the target source 1 may also be composed of a plurality of discrete sub-target sources; still for example, these sub-target sources are arranged on an annular driving belt so that it is possible to use these sub-target sources in turn, thus further ensuring the uniformity of the deposition.

As illustrated in Figs.1 and 2, for example, the target source 1 may be provided in parallel to the ground, and the infrared heating section 4 may be located above the target source 1. Alternatively, the infrared heating section 4 may be provided in parallel to the ground, and the target source 1 may be located above the infrared heating section 4. Still alternatively, the target source 1 and the infrared heating section 4 are all provided perpendicular to the ground.

For example, the infrared temperature detecting section 3 comprises an infrared camera or the like.

For example, the signal processing section 6 comprises a central processing unit (CPU), an image processing unit (GPU), a digital signal processor (DSP), a programmable logic controller or the like, and if required, may further comprise a memory, an input/output unit (e.g., a display, a touch screen, a touch pad, a keyboard, a cursor mouse and the like), or the like.

For example, the actuation section 7 comprises relays, drive electrodes, and the like.

The mobile target coating device of the embodiments of the present disclosure may be applied to various coating manners, including but not limited to magnetron sputtering method, vacuum vapor deposition method, and the like. Such a mobile target coating device is also suitable for the preparation of various material films, such as anode films, including but not limited to indium tin oxide film (ITO), zinc oxide tin film (IZO), and the like. In the mobile target coating device provided by the embodiments of the present disclosure, the infrared temperature detecting section detects the surface temperature of the target source 1 in real time, and the infrared heating section 4 heats duly the portion of the surface of the target source 1 having a lower temperature according to the detected temperature distribution information, thus ensuring uniform surface temperature of the target source 1 in the process of coating, and it is possible to obtain an anode film in which the resistance distribution is uniform over the entire plate. In one embodiment of the present disclosure, the resistivity of the anode film reaches up to 2×10⁻⁴Ω/cm, and its transmittance reaches up to 90% or more; the efficiency of operation and the product quality of the anode film are all enormously improved; the production cost is saved, and the service life thereof is extended by 2 times or above, and it results in energy-saving and environmental friendly.

## Claims

1. A mobile target coating device, comprising:
a target source (1);
a target source carrier section (2) configured to carry and drive the target source (1) to move;
an infrared temperature detecting section (3), connected to the target source carrier section (2) and configured to detect a temperature of a surface of the target source (1);
an infrared heating section (4), connected to the target source carrier section (2), configured to heat the target source (1), and comprising an infrared heating radiating sheet (41); and
a control section (10), in signal communication with the infrared temperature detecting section (3) and the infrared heating section (4), and configured to receive a detection signal of the infrared temperature detecting section (3) and determine whether the temperature of the surface of the target source (1) is uniform or not, and comprising an actuation section (7), the actuation section (7) comprising a rotating motor (71), and the infrared heating radiating sheet (41) being connected with the rotating motor (71),
wherein the control section (10) further comprises a signal connecting portion (5) and a signal processing section (6) and is further configured to, during the infrared heating section (4) heats the target source (1), determine whether a temperature of a portion of the surface of the target source (1) is lower than a temperature of other portions of the surface of the target source (1) and a temperature difference value exceeds a pre-set value, issue an instruction to the actuation section (7) by means of the signal processing section (6) such that the rotating motor (71) controls the infrared heating radiating sheet (41) connected therewith to turn on, control the infrared heating radiating sheet (41) to heat the surface of the target source (1) at the portion having the lower temperature until the temperature of the surface of the target source (1) becomes uniform, and stop heating after the temperature of the surface of the target source (1) becomes uniform;
the infrared temperature detecting section (3) and the infrared heating section (4) can move in synchronism with the target source carrier section (2);
the infrared temperature detecting section (3) is located between the surface of the target source (1) and a surface of the infrared heating section (4);
the surface of the target source (1) is composed of a plurality of discrete sub-target sources; and
the plurality of discrete sub-target sources are arranged in an annular arrangement.

2. The mobile target coating device according to claim 1, wherein the surface of the target source (1) is essentially parallel to a surface of the infrared heating section (4);
normal projections of the target source (1) and the infrared heating section (4) on a same plane at least partially overlap with each other.

3. The mobile target coating device according to claim 2, wherein an area size of the target source (1) is less than or equal to an area size of the infrared heating section (4).

4. The mobile target coating device according to any one of claims 1 to 3, wherein the target source carrier section (2) comprises a guide rail (22, 24) and a target source support member (21, 23), and the target source support member (21, 23) is configured to move on the guide rail (22, 24) when the target source (1) is required to move.

5. The mobile target coating device according to claim 4, wherein the guide rail is a maglev track (22), and the maglev track (22) and the target source support member (21) are configured to generate an electromagnetic repulsive force therebetween so as to hold up the target source support member (21) into a suspended state.

6. The mobile target coating device according to claim 4, wherein the guide rail comprises an air-cushion track (24) on which a plurality of air holes (25) are provided facing the target source support member (23), the plurality of air holes (25) on the air-cushion track (24) are configured to eject high-speed gas flows so as to hold up the target source support member (23) into a suspended state.

7. A coating method using the mobile target coating device according to any one of claims 1 to 6, wherein the method comprises:
during the infrared heating section (4) heats the target source (1), the control section (10) receives a detection signal from the infrared temperature detecting section (3), and determines whether the temperature of the surface of the target source (1) is uniform or not;
in a case where the control section (10) determines that a temperature of a portion of the surface of the target source (1) is lower than a temperature of other portions of the surface of the target source (1) and a temperature difference value exceeds a pre-set value, the control section (10) issues an instruction to the actuation section (7) by means of the signal processing section (6) such that the rotating motor (71) controls the infrared heating radiating sheet (41) connected therewith to turn on, and controls the infrared heating radiating sheet (41) to heat the surface of the target source (1) at the portion having the lower temperature until the temperature of the surface of the target source (1) becomes uniform; and
the control section (10) controls the infrared heating radiating sheet (41) to stop heating after the temperature of the surface of the target source (1) becomes uniform.

## Patentansprüche

1. Mobile Zielbeschichtungsvorrichtung, mit:
einer Zielquelle (1);
einen Zielquellenträgerabschnitt (2), der konfiguriert ist, die Zielquelle (1) zu tragen und anzutreiben, um sie zu bewegen;
einem Infrarot-Temperaturerfassungsabschnitt (3), der mit dem Zielquellenträgerabschnitt (2) verbunden und konfiguriert ist, eine Temperatur einer Oberfläche der Zielquelle (1) zu erfassen;
einem Infrarot-Heizabschnitt (4), der mit dem Zielquellenträgerabschnitt (2) verbunden und konfiguriert ist, die Zielquelle (1) zu erwärmen, und der ein Infrarot-Heizstrahlungsblech (41) aufweist; und
einem Steuerabschnitt (10), der in Signalkommunikation mit dem Infrarot-Temperaturerfassungsabschnitt (3) und dem Infrarot-Heizabschnitt (4) steht und konfiguriert ist, ein Erfassungssignal des Infrarot-Temperaturerfassungsabschnitts (3) zu empfangen und zu bestimmen, ob die Temperatur der Oberfläche der Zielquelle (1) gleichmäßig ist oder nicht, und einen Aktuatorabschnitt (7) aufweist, wobei der Aktuatorabschnitt (7) einen Drehmotor (71) aufweist, und das Infrarot-Heizstrahlungsblech (41) mit dem Drehmotor (71) verbunden ist,
wobei der Steuerabschnitt (10) ferner einen Signalverbindungsteil (5) und einen Signalverarbeitungsabschnitt (6) aufweist und ferner konfiguriert ist, während der Infrarot-Heizabschnitt (4) die Zielquelle (1) aufheizt, zu bestimmen, ob eine Temperatur eines Teils der Oberfläche der Zielquelle (1) niedriger ist als eine Temperatur anderer Teile der Oberfläche der Zielquelle (1) und ein Temperaturdifferenzwert einen voreingestellten Wert überschreitet, einen Befehl an den Aktuatorabschnitt (7) mittels des Signalverarbeitungsabschnitts (6) derart ausgibt, dass der Drehmotor (71) das damit verbundene Infrarot-Heizstrahlungsblech (41) steuert, um es einzuschalten, das Infrarot-Heizstrahlungsblech (41) steuert, um die Oberfläche der Zielquelle (1) an dem Teil mit der niedrigeren Temperatur zu erwärmen, bis die Temperatur der Oberfläche der Zielquelle (1) gleichmäßig wird, und die Erwärmung stoppt, nachdem die Temperatur der Oberfläche der Zielquelle (1) gleichmäßig geworden ist;
der Infrarot-Temperaturerfassungsabschnitt (3) und der Infrarot-Heizabschnitt (4) synchron mit dem Zielquellenträgerabschnitt (2) bewegbar sind;
der Infrarot-Temperaturerfassungsabschnitt (3) sich zwischen der Oberfläche der Zielquelle (1) und einer Oberfläche des Infrarot-Heizabschnitts (4) befindet;
die Oberfläche der Zielquelle (1) aus einer Vielzahl von diskreten Teilzielquellen zusammengesetzt ist; und
die Vielzahl der diskreten Teilzielquellen ringförmig angeordnet ist.

2. Mobile Zielbeschichtungsvorrichtung nach Anspruch 1, wobei
die Oberfläche der Zielquelle (1) im Wesentlichen parallel zu einer Oberfläche des Infrarot-Heizabschnitts (4) ist;
normale Projektionen der Zielquelle (1) und des Infrarot-Heizabschnitts (4) auf derselben Ebene einander zumindest teilweise überlappen.

3. Mobile Zielbeschichtungsvorrichtung nach Anspruch 2, wobei eine Flächengröße der Zielquelle (1) kleiner oder gleich einer Flächengröße des Infrarot-Heizabschnitts (4) ist.

4. Mobile Zielbeschichtungsvorrichtung nach einem der Ansprüche 1 bis 3, wobei der Zielquellenträgerabschnitt (2) eine Führungsschiene (22, 24) und ein Zielquellenträgerelement (21, 23) aufweist und das Zielquellenträgerelement (21, 23) konfiguriert ist, sich auf der Führungsschiene (22, 24) zu bewegen, wenn eine Bewegung der Zielquelle (1) erforderlich ist.

5. Mobile Zielbeschichtungsvorrichtung nach Anspruch 4, wobei die Führungsschiene eine Magnetschwebeschiene (22) ist und die Magnetschwebeschiene (22) und das Zielquellen-Stützelement (21) konfiguriert sind, eine elektromagnetische Abstoßungskraft dazwischen zu erzeugen, sodass das Zielquellen-Stützelement (21) in einem schwebenden Zustand gehalten wird.

6. Mobile Zielbeschichtungsvorrichtung nach Anspruch 4, wobei die Führungsschiene eine Luftkissenbahn (24) aufweist, auf der eine Vielzahl von Luftlöchern (25) bereitgestellt sind, die dem Zielquellen-Stützelement (23) zugewandt sind, wobei die Vielzahl von Luftlöchern (25) auf der Luftkissenbahn (24) konfiguriert ist, Gasströmungen mit hoher Geschwindigkeit auszustoßen, sodass das Zielquellen-Stützelement (23) in einem hängenden Zustand gehalten wird.

7. Beschichtungsverfahren unter Verwendung der mobilen Zielbeschichtungsvorrichtung nach einem der Ansprüche 1 bis 6, wobei das Verfahren aufweist:
während der Infrarot-Heizabschnitt (4) die Zielquelle (1) aufheizt, empfängt der Steuerabschnitt (10) ein Erfassungssignal von dem Infrarot-Temperaturerfassungsabschnitt (3) und bestimmt, ob die Temperatur der Oberfläche der Zielquelle (1) gleichmäßig ist oder nicht;
falls der Steuerabschnitt (10) bestimmt, dass die Temperatur eines Teils der Oberfläche der Zielquelle (1) niedriger ist als die Temperatur anderer Teile der Oberfläche der Zielquelle (1) und ein Temperaturdifferenzwert einen voreingestellten Wert überschreitet, der Steuerabschnitt (10) mittels des Signalverarbeitungsabschnitts (6) derart einen Befehl an den Aktuatorabschnitt (7) ausgibt, dass der Drehmotor (71) das mit ihm verbundene Infrarot-Heizstrahlungsblech (41) steuert, um es einzuschalten, und das Infrarot-Heizstrahlungsblech (41) steuert, um die Oberfläche der Zielquelle (1) an dem Teil mit der niedrigeren Temperatur zu erwärmen, bis die Temperatur der Oberfläche der Zielquelle (1) gleichmäßig wird; und
der Steuerabschnitt (10) das Infrarot-Heizstrahlungsblech (41) so steuert, dass es die Erwärmung beendet, nachdem die Temperatur der Oberfläche der Zielquelle (1) gleichmäßig geworden ist.

## Revendications

1. Dispositif de revêtement à cible mobile, comprenant :
une source cible (1) ;
une section de transport de source cible (2) qui est configurée pour déplacer par entraînement la source cible (1) ;
une section de détection de température infrarouge (3) qui est connectée à la section de transport de source cible (2) et qui est configurée pour détecter une température d'une surface de la source cible (1) ;
une section de chauffage infrarouge (4) qui est connectée à la section de transport de source cible (2), qui est configurée pour chauffer la source cible (1) et qui comprend une feuille rayonnante de chauffage infrarouge (41) ; et
une section de commande (10) qui est en communication en termes de signal avec la section de détection de température infrarouge (3) et la section de chauffage infrarouge (4), qui est configurée pour recevoir un signal de détection de la section de détection de température infrarouge (3) et pour déterminer si la température de la surface de la source cible (1) est uniforme ou non et qui comprend une section d'actionnement (7), la section d'actionnement (7) comprenant un moteur rotatif (71), et la feuille rayonnante de chauffage infrarouge (41) étant connectée au moteur rotatif (71)
dans lequel la section de commande (10) comprend en outre une section de connexion de signal (5) et une section de traitement de signal (6) et est en outre configurée pour, pendant que la section de chauffage infrarouge (4) chauffe la source cible (1), déterminer si une température d'une partie de la surface de la source cible (1) est inférieure à une température d'autres parties de la surface de la source cible (1) et si une valeur de différence de température excède une valeur prédéfinie, délivrer une instruction à la section d'actionnement (7) au moyen de la section de traitement de signal (6) de telle sorte que le moteur rotatif (71) commande la feuille rayonnante de chauffage infrarouge (41) qui lui est connectée pour l'activer, commander la feuille rayonnante de chauffage infrarouge (41) pour chauffer la surface de la source cible (1) au niveau de la partie qui présente la température plus faible jusqu'à ce que la température de la surface de la source cible (1) devienne uniforme, et arrêter le chauffage après que la température de la surface de la source cible (1) est devenue uniforme ;
la section de détection de température infrarouge (3) et la section de chauffage infrarouge (4) peuvent être déplacées en synchronisation avec la section de transport de source cible (2) ;
la section de détection de température infrarouge (3) est localisée entre la surface de la source cible (1) et une surface de la section de chauffage infrarouge (4) ;
la surface de la source cible (1) est constituée par une pluralité de sources sous-cibles discrètes ; et
les sources de la pluralité de sources sous-cibles discrètes sont agencées selon un agencement annulaire.

2. Dispositif de revêtement à cible mobile selon la revendication 1, dans lequel :
la surface de la source cible (1) est essentiellement parallèle à une surface de la section de chauffage infrarouge (4) ;
les projections normales de la source cible (1) et de la section de chauffage infrarouge (4) sur un même plan se chevauchent mutuellement au moins partiellement.

3. Dispositif de revêtement à cible mobile selon la revendication 2, dans lequel une taille de surface de la source cible (1) est inférieure ou égale à une taille de surface de la section de chauffage infrarouge (4).

4. Dispositif de revêtement à cible mobile selon l'une quelconque des revendications 1 à 3, dans lequel la section de transport de source cible (2) comprend un rail de guidage (22, 24) et un élément de support de source cible (21, 23), et l'élément de support de source cible (21, 23) est configuré pour être déplacé sur le rail de guidage (22, 24) lorsque la source cible (1) doit être déplacée.

5. Dispositif de revêtement à cible mobile selon la revendication 4, dans lequel le rail de guidage est une voie à sustentation magnétique (22), et la voie à sustentation magnétique (22) et l'élément de support de source cible (21) sont configurés pour générer une force de répulsion électromagnétique entre eux de manière à maintenir l'élément de support de source cible (21) dans un état suspendu.

6. Dispositif de revêtement à cible mobile selon la revendication 4, dans lequel le rail de guidage comprend une voie à coussin d'air (24) sur laquelle une pluralité de trous de passage d'air (25) sont prévus de telle sorte qu'ils fassent face à l'élément de support de source cible (23), les trous de la pluralité de trous de passage d'air (25) prévus sur la voie à coussin d'air (24) sont configurés pour éjecter des écoulements de gaz haute vitesse de manière à maintenir l'élément de support de source cible (23) dans l'état suspendu.

7. Procédé de revêtement utilisant le dispositif de revêtement à cible mobile selon l'une quelconque des revendications 1 à 6, dans lequel le procédé comprend :
pendant que la section de chauffage infrarouge (4) chauffe la source cible (1), la section de commande (10) reçoit un signal de détection en provenance de la section de détection de température infrarouge (3) et détermine si la température de la surface de la source cible (1) est uniforme ou non ;
dans le cas où la section de commande (10) détermine qu'une température d'une partie de la surface de la source cible (1) est inférieure à une température d'autres parties de la surface de la source cible (1) et qu'une valeur de différence de température excède une valeur prédéfinie, la section de commande (10) délivre une instruction à la section d'actionnement (7) au moyen de la section de traitement de signal (6) de telle sorte que le moteur rotatif (71) commande la feuille rayonnante de chauffage infrarouge (41) qui lui est connectée pour l'activer, et commande la feuille rayonnante de chauffage infrarouge (41) pour chauffer la surface de la source cible (1) au niveau de la partie qui présente la température plus faible jusqu'à ce que la température de la surface de la source cible (1) devienne uniforme ; et
la section de commande (10) commande la feuille rayonnante de chauffage infrarouge (41) pour arrêter le chauffage après que la température de la surface de la source cible (1) est devenue uniforme.
